# DEMANDE DE BREVET EUROPEEN

(11) **EP 2 581 338 A1**
(43) Date de publication de la demande: **17.04.2013**
(21) Numéro de dépôt: 12187740.1
(22) Date de dépôt: 09.10.2012
(51) Int. Cl.: B81C 1/00, H01L 23/26

(54) **Procédé d'encapsulation de micro-dispositif par report de capot et depot de getter à travers le capot**

(30) Priorité: 11.10.2011 FR 1159167
(71) Demandeur: Commissariat à l'Énergie Atomique et aux Énergies Alternatives, 75015 Paris (FR)
(72) Inventeur: Baillin, Xavier, 38920 CROLLES (FR); Pornin, Jean-Louis, 38920 CROLLES (FR)
(74) Mandataire: Ilgart, Jean-Christophe

(57) **Abrégé**

Procédé d'encapsulation d'un micro-dispositif (100) dans une cavité (108) formée entre un premier (102) et un deuxième substrat (106), comportant les étapes de :
- réalisation du micro-dispositif dans et/ou sur le premier substrat,
- report et solidarisation du deuxième substrat au premier substrat, formant la cavité dans laquelle est disposé le micro-dispositif,
- réalisation d'au moins un trou (112) à travers l'une des deux substrats (106), appelé substrat percé, et débouchant dans la cavité en regard d'une partie (113) de l'autre des deux substrats (102), appelé substrat d'accueil,
- dépôt d'au moins une portion de matériau getter (114) sur ladite partie du substrat d'accueil à travers le trou tel que le matériau getter n'obstrue pas le trou,
- fermeture hermétique de la cavité par obturation du trou.

## Description

### DOMAINE TECHNIQUE

L'invention concerne un procédé d'encapsulation d'un micro-dispositif, ou microsystème ou microcomposant, par exemple de type MEMS, NEMS, MOEMS, ou un micro-détecteur infrarouge tel qu'un micro-bolomètre, dans une cavité hermétique formée entre deux substrats et dans laquelle un matériau getter est déposé.

### ÉTAT DE LA TECHNIQUE ANTÉRIEURE

Certains micro-dispositifs tels que ceux de type MEMS, NEMS ou des micro-détecteurs infrarouges nécessitent pour leur bon fonctionnement d'être enfermés, ou encapsulés, de manière hermétique dans une cavité dont l'atmosphère est contrôlée (contrôle notamment de la nature du gaz et de la pression régnant dans la cavité).

La technologie utilisée pour obtenir une telle encapsulation consiste à réaliser tout d'abord ces micro-dispositifs collectivement sur un premier substrat (ou wafer) de silicium. Chacun des micro-dispositifs est ensuite encapsulé dans une cavité formée par report et scellement hermétique d'un capot, par exemple formé par un deuxième substrat de silicium, sur le premier substrat. Cet assemblage hermétique entre le premier et le deuxième substrat, formant de manière collective les cavités d'encapsulation des micro-dispositifs, permet notamment d'empêcher les fuites de gaz entre l'intérieur des cavités et l'environnement extérieur.

L'ajout de getters non évaporables (NEG) dans les cavités, par exemple sous la forme de portions de matériau getter disposées dans ces cavités, permet de contrôler les caractéristiques de l'atmosphère au sein des cavités. Les portions de matériau getter peuvent être réalisées à partir d'un dépôt en couche mince du matériau getter sur l'un ou l'autre des deux substrats, préalablement à l'opération d'assemblage entre les deux substrats. Une mise en forme des portions de matériau getter dans le plan des deux substrats est ensuite réalisée par des opérations technologiques de photolithographie et de gravure de la couche mince de matériau getter.

En variante, il est possible de déposer le matériau getter de manière discrète, directement sous la forme souhaitée. Pour cela, le matériau getter peut être déposé directement sur l'un ou l'autre des deux substrats par lift-off, à travers un film de résine photosensible préalablement mis en forme par photolithographie, ce film étant retiré après le dépôt du matériau getter à travers celui-ci.

Dans ces deux cas, la réalisation des portions de matériau getter nécessite l'utilisation d'une résine déposée sur le matériau getter qui, par interaction chimique avec le matériau getter, peut dégrader les capacités de pompage du matériau getter.

Afin de limiter ce risque d'interaction chimique, le matériau getter peut être déposé à travers un pochoir. Ainsi, on évite l'utilisation de résines qui peuvent dégrader les capacités de pompage du matériau getter. En contrepartie, l'utilisation d'un tel pochoir s'avère coûteux car, d'une part, il est nécessaire de réaliser un pochoir spécifique à la structure d'encapsulation (pour déposer le matériau getter aux emplacements souhaités), et que d'autre part des manipulations d'assemblages temporaires pochoir - substrat doivent être réalisées dans les machines de dépôt. De plus, il est également nécessaire de nettoyer le pochoir après un certain nombre d'utilisations.

Enfin, il est difficile de contrôler précisément les dimensions finales du matériau getter dans le plan du substrat sur lequel le matériau getter est déposé puisque d'une part, pour une question de tenue mécanique, le pochoir doit avoir une épaisseur de plusieurs centaines de microns, et que d'autre part la distance entre le pochoir et le substrat lors du dépôt du matériau getter est importante (généralement d'au moins une centaine de microns). L'épaisseur importante de l'assemblage temporaire substrat - pochoir pose également des inconvénients liés à la manipulation d'un tel assemblage qui peut être incompatible avec certaines machines de dépôt. Des imprécisions liées à l'alignement entre le pochoir et le substrat peuvent également se répercuter sur le positionnement des portions de matériau getter déposées sur le substrat.

Dans tous les cas précédemment décrits, du fait que le matériau getter est déposé sur l'un des deux substrats préalablement au cycle d'assemblage entre les deux substrats, le matériau getter est donc exposé à l'atmosphère de l'enceinte dans laquelle est réalisé le scellement des deux substrats entre eux. La première conséquence de cette exposition est qu'il est nécessaire de faire l'adéquation entre la température d'activation thermique du matériau getter et la température atteinte lors du scellement des deux substrats entre eux de façon à ne pas altérer le matériau getter lorsqu'il est exposé à l'ambiance gazeuse de l'enceinte. En effet, si le matériau getter devenait actif avant la fin du scellement, il commencerait alors à pomper les gaz environnants avant la fermeture de la cavité. Il n'est donc pas possible de dégazer les substrats à une température supérieure à la température d'activation thermique du matériau getter. Or, afin de bien contrôler l'atmosphère finale dans la cavité renfermant le micro-dispositif, on réalise un dégazage des parois qui délimitent la cavité.

En alternative, le micro-dispositif peut être encapsulé avec un packaging en couche mince (PCM) qui consiste à encapsuler le micro-dispositif dans une cavité délimitée par le substrat, sur lequel est réalisé le micro-dispositif, et un film, ou couche mince, d'encapsulation déposé sur le substrat et formant le capot. Au moins un évent, ou trou de libération, est réalisé à travers la couche mince d'encapsulation afin d'éliminer une résine sacrificielle recouvrant le micro-dispositif et sur laquelle est déposée la couche mince formant le capot, libérant ainsi le micro-dispositif et créant la cavité. Le trou de libération est ensuite bouché. Un matériau getter peut être réalisé au préalable sur le substrat afin d'être encapsulé dans la cavité avec le micro-dispositif.

Une telle encapsulation PCM implique là encore l'utilisation d'une résine pouvant dégrader les capacités de pompage du matériau getter. De plus, le matériau getter est exposé à des procédés oxydants permettant d'éliminer la résine et qui vont contribuer à réduire sa capacité de pompage.

Le brevet US 2008/049386 A1 fournit une solution qui consiste à ne pas réaliser le matériau getter préalablement à la réalisation de la cavité, mais à boucher les trous de libération avec le matériau getter. Toutefois, compte tenu d'une part de la taille limité (au plus quelques microns de diamètre) et de la géométrie des trous de libération, et d'autre part de la hauteur limitée de la cavité (également de l'ordre de quelques microns), il n'est pas possible de réaliser une surface importante de matériau getter dans la cavité. De plus, il est difficile de contrôler la structure du matériau getter obtenu, et donc également de contrôler sa température d'activation thermique.

Cela peut conduire à réaliser une activation thermique du matériau getter avec une température trop élevée entraînant un dégazage des surfaces internes de la cavité. Enfin, avec un tel procédé, il existe également un risque de pollution du matériau getter par le carbone si la résine sacrificielle n'est pas complètement éliminée.

### EXPOSÉ DE L'INVENTION

Un but de la présente invention est de proposer un procédé d'encapsulation d'un micro-dispositif ne faisant pas appel à une résine pour former le capot et ne présentant pas les inconvénients des procédés de l'art antérieur exposés précédemment.

Pour cela, la présente invention propose un procédé d'encapsulation d'un micro-dispositif dans une cavité formée entre au moins un premier et un deuxième substrat, comportant au moins les étapes de :
- réalisation du micro-dispositif dans et/ou sur le premier substrat,
- report et solidarisation du deuxième substrat au premier substrat, formant la cavité dans laquelle est disposé le micro-dispositif,
- réalisation d'au moins un trou à travers l'un des deux substrats, appelé substrat percé, et débouchant dans la cavité en regard d'une partie de l'autre des deux substrats, appelé substrat d'accueil,
- dépôt d'au moins une portion de matériau getter sur ladite partie du substrat d'accueil à travers le trou,
- fermeture hermétique de la cavité par obturation du trou.

Ainsi, le ou les trous peuvent être réalisés à travers le premier substrat qui comporte le micro-dispositif, ou à travers le deuxième substrat qui forme le capot de la cavité, l'un ou l'autre des deux substrats pouvant correspondre au substrat percé.

On peut également envisager de réaliser des trous à travers les deux substrats afin de déposer des portions de matériau getter dans la cavité, contre les deux substrats (en prenant soin par exemple de ne pas réaliser les trous les uns en face des autres). Dans ce cas, chaque substrat (premier et deuxième substrats) forme à la fois un substrat d'accueil destiné à recevoir du matériau getter et un substrat percé comportant un ou plusieurs trous à travers lesquels du matériau getter peut être déposé.

Dans le procédé d'encapsulation selon la présente invention, le matériau getter est déposé dans la cavité après l'assemblage des deux substrats formant la cavité. Du fait que le capot soit formé par un substrat et non par une couche mince, on améliore la solidité du capot, rendant possible la réalisation d'un ou plusieurs trous dont la forme et les dimensions ne sont pas limitées. Il devient donc possible de déposer des portions de matériau getter de dimensions plus importantes dans la cavité.

Le procédé d'encapsulation selon l'invention offre une grande liberté de positionnement du matériau getter dans la cavité car il n'y a pas de contraintes sur les dimensions, la forme ou le positionnement du ou des trous à travers lequel ou lesquels le matériau getter est déposé. En choisissant le nombre, la forme et les dimensions des trous tels qu'ils correspondent au nombre, à la forme et aux dimensions des portions de matériau getter que l'on souhaite réaliser dans la cavité, le getter est directement déposé aux cotes souhaitées et à l'intérieur de la cavité formée par les deux substrats assemblés l'un à l'autre. Le substrat formant le capot et/ou le substrat qui comporte le micro-dispositif sert donc de pochoir à travers lequel le matériau getter est déposé.

Le terme « substrat » désigne une couche, ou un multicouche, d'épaisseur généralement supérieure ou égale à environ 10 µm, cette épaisseur distinguant un substrat d'une couche mince dont l'épaisseur n'est que de quelques microns.

Du fait que la cavité est réalisée par le report et la solidarisation du deuxième substrat, formant le capot, au premier substrat, et non par PCM, on évite l'utilisation d'une résine pour former le capot, ce qui préserve le micro-dispositif de tout endommagement dû à l'élimination de la résine, ou d'un mauvais fonctionnement dû à de la résine restante mal éliminée qui pourrait également polluer le matériau getter.

Le procédé d'encapsulation selon l'invention permet d'éviter l'utilisation d'un pochoir disposé temporairement sur le substrat qui, outre les inconvénients liés à ce pochoir qui on été précédemment décrits, peut également endommager le substrat et le micro-dispositif en raison de la solidarisation temporaire. De plus, par rapport à un procédé faisant appel à un tel pochoir, le procédé d'encapsulation selon l'invention réduit le nombre de manipulations du substrat réalisées pour encapsuler le micro-dispositif, et évite également une contamination des éléments liée à la désolidarisation du pochoir et du substrat.

Le procédé d'encapsulation selon l'invention permet également, du fait que le matériau getter soit réalisé sur le substrat d'accueil après la solidarisation du deuxième substrat au premier substrat, d'éviter l'exposition du matériau getter aux gaz présents lors de cette solidarisation.

Le procédé d'encapsulation selon l'invention s'applique pour tout type de micro-dispositifs, par exemple des NEMS, MEMS, MOEMS ou des micro-détecteurs infrarouges tels que des micro-bolomètres, ou de toute autre nature.

Le procédé d'encapsulation selon l'invention peut être mis en oeuvre pour réaliser une encapsulation collective de plusieurs micro-dispositifs sous atmosphère contrôlée dans différentes cavités formées par l'assemblage du premier substrat au deuxième substrat.

Le dépôt de la portion de matériau getter peut être réalisé sous un vide poussé, par exemple dans un évaporateur, permettant ainsi d'améliorer la qualité de l'atmosphère finale (nature des gaz et pressions partielles) régnant dans la cavité.

Le dépôt de la portion de matériau getter peut être mis en oeuvre tel que le matériau getter n'obstrue pas le trou. Ainsi, après la mise en oeuvre du dépôt du matériau getter et avant la fermeture hermétique de la cavité par obturation, ou obstruction ou encore bouchage, du trou, il est possible d'accéder à la cavité par le trou qui n'est pas obstrué par le matériau getter.

De façon avantageuse, les dimensions du ou des trous sont les plus grandes possible afin de maximiser la surface du matériau getter déposé par rapport aux surfaces libres du support recevant le matériau getter.

Les dimensions du trou, dans un plan parallèle à l'une des faces principales du substrat percé, peuvent être supérieures ou égales à environ 10 µm, et/ou l'épaisseur du substrat percé peut être supérieure ou égale à environ 50 µm.

Le procédé d'encapsulation peut comporter en outre la mise en oeuvre, avant le report et la solidarisation du deuxième substrat au premier substrat, d'une étape de structuration de ladite partie du substrat d'accueil, formant un relief au niveau de ladite partie du substrat d'accueil, la portion de matériau getter étant déposée sur au moins une partie des parois dudit relief. La portion de matériau getter peut être déposée telle qu'elle recouvre la totalité des parois dudit relief. En déposant la portion de matériau getter sur un tel relief, on augmente, pour une même surface d'occupation du substrat d'accueil, la surface de matériau getter exposée dans la cavité. Ce relief peut être en creux ou en bosse. Le relief peut être tel que, pour un même encombrement sur le substrat d'accueil, la surface de matériau getter en contact avec l'atmosphère de la cavité soit plus importante que celle obtenue pour un matériau getter déposé sur une surface plane du substrat d'accueil.

Le relief peut former par exemple une ou plusieurs rainures au niveau de ladite partie du substrat d'accueil.

Le deuxième substrat peut être solidarisé au premier substrat par l'intermédiaire d'un cordon de scellement formant des parois latérales de la cavité ou par un scellement réalisé directement entre le deuxième substrat et le premier substrat.

Le procédé d'encapsulation peut comporter en outre, entre l'étape de report et de solidarisation du deuxième substrat au premier substrat et l'étape de fermeture hermétique de la cavité, la mise en oeuvre d'un amincissement du substrat percé. Un tel amincissement peut permettre d'utiliser dans un premier temps (lors de l'assemblage des deux substrats) un substrat épais, l'amincissement permettant ensuite la réalisation du ou des trous à travers ce substrat. De manière générale, un tel amincissement peut être mis en oeuvre avant la réalisation du ou des trous à travers le substrat percé.

Avant la mise en oeuvre de l'étape de report et de solidarisation du deuxième substrat au premier substrat, le trou peut être réalisé en partie à travers une face du substrat percé destinée à former une paroi de la cavité, c'est-à-dire dans une partie de l'épaisseur du substrat percé.

Le procédé d'encapsulation peut comporter en outre, entre l'étape de réalisation du trou et l'étape de dépôt de la portion de matériau getter, la mise en oeuvre d'un dégazage des parois de la cavité par un traitement thermique du premier et du deuxième substrat, et/ou la mise en oeuvre d'un dépôt d'au moins un matériau contre les parois du trou, bouchant en partie le trou, et/ou la mise en oeuvre d'un dépôt d'au moins un matériau sur ladite partie du substrat d'accueil en formant un relief sur ladite partie du substrat d'accueil, la portion de matériau getter étant déposée sur au moins une partie des parois dudit relief. Ainsi, lorsque la surface du substrat d'accueil n'est pas structurée, le matériau déposé sur le substrat d'accueil en formant le relief peut permettre de former un amas de matériau préalablement au dépôt du matériau getter. Cet amas peut former alors un relief qui permet d'obtenir ensuite une surface plus importante de matériau getter exposée dans la cavité. Ce matériau peut également servir de sous-couche d'ajustement de la température d'activation du matériau getter. De plus, le dépôt de matériau contre les parois du trou, bouchant en partie le trou, peut faciliter le bouchage ultérieur du trou.

Du fait que l'assemblage des deux substrats et que la réalisation du ou des trous à travers le substrat percé sont réalisés avant le dépôt du matériau getter à travers ce ou ces trous, il est possible de réaliser un dégazage des parois de la cavité avant de déposer la ou les portions de matériau getter dans la cavité. On évite ainsi au matériau getter d'être contaminé par les gaz dégagés lors de ce dégazage.

La fermeture hermétique de la cavité par obturation du trou peut être réalisée par la mise en oeuvre d'au moins une étape de dépôt, sur le substrat percé, d'au moins une portion et/ou une couche de matériau recouvrant au moins le trou, et/ou au moins une étape de solidarisation d'un troisième substrat sur le substrat percé.

Le procédé peut comporter en outre, après la fermeture hermétique de la cavité par obturation du trou, la mise en oeuvre d'un traitement thermique activant thermiquement la portion de matériau getter.

Le procédé peut comporter en outre, préalablement au dépôt de la portion de matériau getter, une étape de dépôt, au moins sur ladite partie du substrat d'accueil, d'au moins un matériau d'ajustement apte à modifier la température d'activation thermique de la portion de matériau getter, la portion de matériau getter étant déposée sur ledit matériau d'ajustement.

Les dimensions du trou, au niveau d'une face du substrat percé formant une paroi de la cavité, peuvent être inférieures aux dimensions du trou au niveau d'une face du substrat percé opposée à celle formant une paroi de la cavité. Dans ce cas, le trou peut avoir une forme « d'entonnoir », facilitant le dépôt du matériau getter à travers celui-ci.

L'étape de réalisation du trou peut être mise en oeuvre avant l'étape de report et de solidarisation du deuxième substrat au premier substrat.

La portion de matériau getter déposée peut ne pas être en contact avec le substrat percé.

Le matériau getter peut être non-poreux.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1H représentent des étapes d'un procédé d'encapsulation d'un micro-dispositif, objet de la présente invention, selon un mode de réalisation particulier,
- les figures 2 à 8 représentent différentes variantes de réalisation du procédé d'encapsulation du micro-dispositif, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

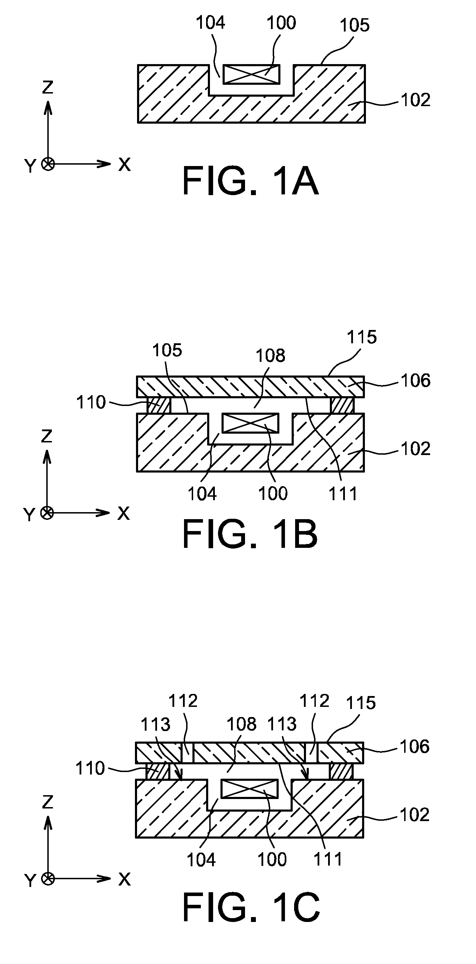

On se réfère aux figures 1A à 1E qui représentent les étapes d'un procédé d'encapsulation d'un micro-dispositif 100, selon un mode de réalisation particulier.

Le micro-dispositif 100, par exemple de type MEMS et/ou NEMS, est tout d'abord réalisé sur et/ou dans un premier substrat 102, par exemple composé de semi-conducteur tel que du silicium (figure 1A).

Dans ce premier mode de réalisation, le micro-dispositif 100, qui comporte une partie mobile, est au moins en partie suspendu au-dessus d'un espace 104 réalisé dans le premier substrat 102 au niveau d'une face d'accueil 105 destinée à être disposée du côté de la cavité dans laquelle le micro-dispositif 100 va être encapsulé. Le premier substrat 102 a par exemple une épaisseur égale à plusieurs centaines de microns.

Comme représenté sur la figure 1B, un capot, formé ici par un deuxième substrat 106 composé par exemple de semi-conducteur, tel que du silicium, ou de verre, est solidarisé au premier substrat 102, formant une cavité 108 dans laquelle est disposé le micro-dispositif 100. Le deuxième substrat 106 a par exemple une épaisseur supérieure ou égale à environ 10 µm, par exemple comprise entre environ 10 µm et 1 mm, et de préférence supérieure à environ 50 µm.

Le deuxième substrat 106 est solidarisé au premier substrat 102 par l'intermédiaire d'un cordon de scellement 110 composé par exemple d'un matériau fusible. Dans une variante, le cordon de scellement peut être composé d'au moins un matériau getter, permettant ainsi d'augmenter, à la fin du procédé d'encapsulation, la surface de matériau getter exposée à l'atmosphère de la cavité 108. La cavité 108 est donc délimitée par le premier substrat 102, le deuxième substrat 106 et le cordon de scellement 110 qui forment les parois internes de la cavité 108. La distance entre le premier substrat 102 et le deuxième substrat 106, correspondant ici à l'épaisseur du cordon de scellement 110, est par exemple comprise entre 5 µm et 10 µm, voir supérieure à 10 µm.

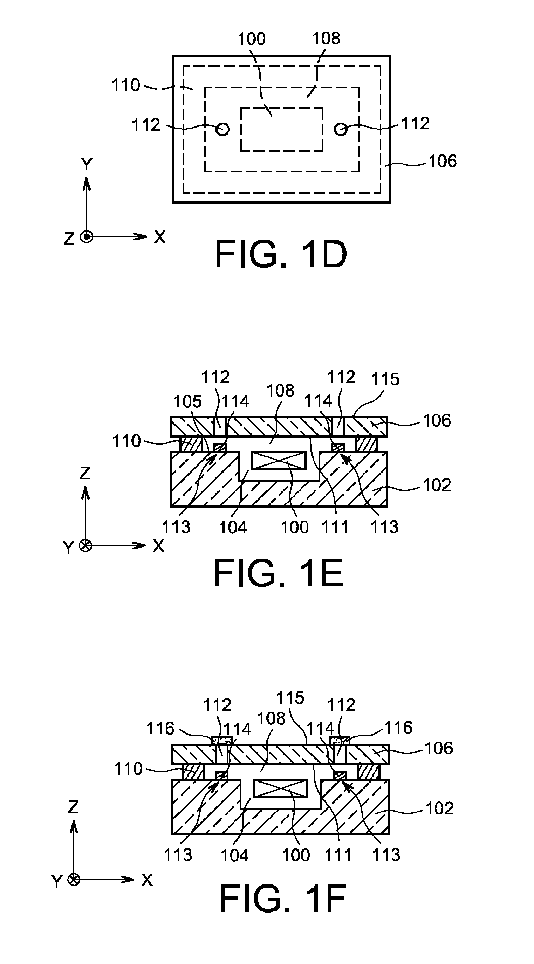

Des trous 112, ou ouvertures, sont ensuite réalisés à travers le deuxième substrat 106, traversant toute l'épaisseur du deuxième substrat 106 et formant un accès à l'intérieur de la cavité 108 depuis l'extérieur (figures 1C et 1D). Ces trous 112 sont destinés à former un accès à la cavité 108 pour déposer sur le premier substrat 102 des portions de matériau getter. Ainsi, chaque trou 112 est réalisé tel qu'il débouche sur une partie 113 du premier substrat 102 (faisant partie de la face 105) apte à recevoir une portion de matériau getter. Le premier substrat 102 forme donc un substrat d'accueil sur lequel du matériau getter est destiné à être déposé, le deuxième substrat 106 formant un substrat percé comportant un ou plusieurs trous à travers lesquels le matériau getter est destiné à être déposé. Dans l'exemple décrit ici, les trous 112 ne débouchent pas au-dessus du micro-dispositif 100, mais à côté de celui-ci. Toutefois, si le matériau getter destiné à être déposé dans la cavité 108 n'affecte pas le fonctionnement du micro-dispositif 100, il est possible qu'au moins une partie du ou des trous 112 débouche au-dessus du micro-dispositif 100. On voit sur la figure 1E que les trous 112 débouchent sur des portions 113 du premier substrat 102 qui sont périphériques à l'espace 104 usiné dans le premier substrat 102 et dans lequel se trouve le micro-dispositif 100.

Dans ce premier mode de réalisation, les trous 112 ont une forme sensiblement cylindrique et présentent un diamètre compris entre environ 2 µm et 100 µm afin que du matériau getter puisse être déposé à travers ces trous 112. Les dimensions des trous 112 dans un plan parallèle à l'une des faces principales 111 et 115 du deuxième substrat 106, c'est-à-dire dans un plan parallèle au plan (X,Y), sont par exemple supérieures à environ 10 µm, permettant ainsi de déposer sur le premier substrat 102 des portions de matériau getter de dimensions (parallèles au plan (X,Y)) supérieures à environ 10 µm. Lorsque le deuxième substrat 106 est composé de semi-conducteur, les trous 112 peuvent être réalisés par photolithographie et gravure anisotrope, par exemple une gravure ionique réactive profonde (DRIE). Lorsque le deuxième substrat 106 est composé de verre, les trous 112 peuvent être réalisés tout d'abord par photolithographie et sablage sur une grande partie de l'épaisseur du substrat, puis achevés par une gravure sèche (par exemple par une gravure par faisceau ionique IBE) à travers le reste de l'épaisseur du substrat. La résine déposée sur le deuxième substrat 106 pour graver les trous 112 est ensuite retirée par voie sèche.

Préalablement à la réalisation des trous 112, le deuxième substrat 106 peut subir une étape d'amincissement, par exemple par CMP (polissage mécano-chimique) afin que celui-ci ait une épaisseur compatible avec la réalisation des trous 112 à travers celui-ci et par exemple comprise entre environ quelques dizaines de micromètres et 1 mm.

Dans une variante, préalablement à l'assemblage du deuxième substrat 106 au premier substrat 102, les trous 112 peuvent être en partie réalisés à travers le deuxième substrat 106, formant des trous traversant une partie de l'épaisseur du deuxième substrat 106, du côté d'une face 111 du deuxième substrat 106 destinée à former une paroi de la cavité 108. Ces trous non traversant peuvent être réalisés par photolithographie et gravure ou sablage selon la nature du deuxième substrat 106. Les trous 112 sont ensuite achevés après l'assemblage du deuxième substrat 106 au premier substrat 102 soit en réalisant un amincissement du deuxième substrat 106, ouvrant ainsi les trous du côté d'une face 115 du deuxième substrat 106 opposée à la face 111, soit en réalisant des étapes de photolithographie et gravure, ou en réalisant successivement ces étapes, afin que les trous préalablement réalisés dans le deuxième substrat 106 se prolongent à travers toute l'épaisseur du deuxième substrat 106, et former ainsi les trous 112.

On fait ensuite subir à la structure représentée sur les figures 1C et 1D, et notamment au premier substrat 102 et au deuxième substrat 106, un traitement thermique sous vide afin de réaliser un dégazage des parois de la cavité 108 formées par le premier substrat 102 et le deuxième substrat 106. Les gaz rejetés dans la cavité 108 sont évacués à l'extérieur de la cavité 108 grâce aux trous 112.

Comme représenté sur la figure 1E, des portions de matériau getter 114 sont ensuite déposées sur le premier substrat 102, autour du micro-dispositif 100, au niveau des parties 113 du premier substrat 102 se trouvant en regard des trous 112. Les portions de matériau getter 114 réalisées ont une forme et des dimensions correspondant sensiblement à celles des trous 112. Sur l'exemple de la figure 1E, les portions de matériau getter 114 ont donc une forme sensiblement cylindrique, voir conique, dont le diamètre à la base correspond approximativement à celui des trous 112. Les portions de matériau getter 114 ont une épaisseur (dimension selon l'axe Z représenté sur la figure 1E) par exemple inférieure à environ 2 µm. Les portions de matériau getter 114 n'obstruent pas les trous 112 et ne sont pas en contact avec le deuxième substrat 106.

Les portions 114 peuvent être composées de n'importe quel matériau getter, c'est-à-dire de n'importe quel matériau présentant des capacités d'absorption et/ou d'adsorption gazeuse. Les portions 114 sont par exemple composées de titane et/ou de vanadium et/ou zirconium et/ou de baryum et/ou de chrome. Les portions 114 peuvent être composées d'un matériau getter non poreux.

Enfin, comme représenté sur la figure 1F, des portions de matériau 116 sont réalisées sur le deuxième substrat 106, au niveau des trous 112 afin de les obturer et ainsi encapsuler hermétiquement dans la cavité 108 le micro-dispositif 100. Une partie du matériau formant les portions 116 peut se trouver dans les trous 112. La forme et les dimensions de ces portions 116 sont telles qu'elles obturent complètement les trous 112 et ferment hermétiquement la cavité 108.

Les portions 116 sont par exemple composées d'un matériau fusible, par exemple un matériau métallique à base d'étain.

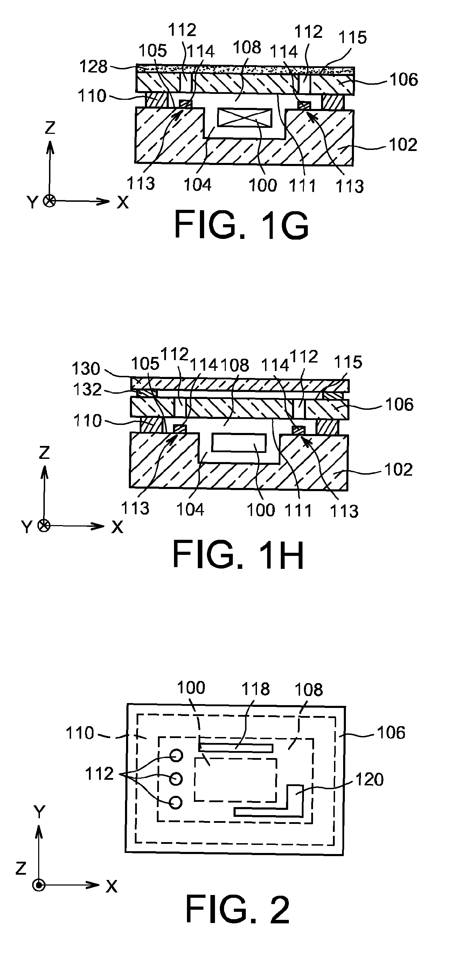

Dans une première variante de réalisation, l'obturation des trous 112 peut être réalisée par une couche de matériau 128, par exemple composée d'au moins un matériau métallique, déposée au moins sur une partie de la face 111 du deuxième substrat 106 et telle qu'elle obture tous les trous 112 (voir figure 1G).

Dans une deuxième variante de réalisation, l'obturation des trous 112 et la fermeture hermétique de la cavité 108 peuvent être réalisées en reportant un troisième substrat 130 sur la face 111 du deuxième substrat 106 et en scellant ce troisième substrat 130 au deuxième substrat 106 par l'intermédiaire d'un matériau fusible 132 disposé entre le deuxième substrat 106 et le troisième substrat 130 (voir figure 1H). Dans ce cas, du matériau getter peut être déposé sur la face 115 du deuxième substrat 106 afin que lors du scellement du troisième substrat 130 au deuxième substrat 106, ce matériau getter provoque une solidification isotherme du matériau fusible 132 disposé entre le deuxième substrat 106 et le troisième substrat 130.

L'assemblage du troisième substrat 130 au deuxième substrat 106 peut être réalisé par un assemblage getter / getter comme décrit dans le document US 2011/0079889 A1. Dans ce cas, après dépôt du matériau getter 114 à travers les trous 112, la face extérieure 115 du deuxième substrat 106 est recouverte de matériau getter. On reporte ensuite par thermocompression le troisième substrat 130 préalablement recouvert d'un matériau getter dont la température d'activation pourra être contrôlée par une sous-couche d'ajustement et avantageusement inférieure à celle du dépôt getter 114 à l'intérieur de la cavité 108. Cet assemblage getter / getter peut aussi être envisagé pour réaliser l'assemblage du deuxième substrat 106 au premier substrat 102.

Le procédé d'encapsulation du micro-dispositif 100 est achevé en réalisant une activation thermique des portions de matériau getter 114, déclenchant ainsi l'absorption et/ou l'adsorption gazeuse dans la cavité 108 par ce matériau getter.

Il est possible de déposer sur les parties 113 du premier substrat 102, préalablement au dépôt des portions de matériau getter 114 (à travers les trous 112 ou directement sur le premier substrat 102 avant l'assemblage des deux substrat 102 et 106), un matériau d'ajustement permettant de modifier la température d'activation thermique des portions des matériaux getters 114 qui sont déposées sur ce matériau d'ajustement. Les détails de réalisation d'un tel matériau d'ajustement sont décrits dans le document EP 2 197 780 B1. Ainsi, on peut par exemple réaliser les portions de matériau getter 114 et ce matériau d'ajustement tel que la température d'activation thermique du matériau getter soit inférieure, par exemple d'au moins 25°C, à la température de dégazage des parois de la cavité 108. On évite ainsi, lors de l'activation thermique du matériau getter, de réaliser de nouveau un dégazage des parois de la cavité 108 qui polluerait le matériau getter. Le matériau d'ajustement de la température d'activation thermique du matériau getter peut être déposé sur les parties 113 du premier substrat 102 préalablement à l'assemblage du deuxième substrat 106 au premier substrat 102, ou bien être déposé après cet assemblage, à travers les trous 112.

Dans l'exemple du procédé d'encapsulation précédemment décrit en liaison avec les figures 1A à 1H, deux trous 112 sont réalisés à travers le deuxième substrat 106. Toutefois, il est possible de réaliser un seul trou, ou plus de deux trous, à travers le deuxième substrat 106. Le nombre de trous, la forme et les dimensions des trous sont adaptés en fonction du nombre, de la forme et des dimensions des portions de matériau getter que l'on souhaite déposer sur le premier substrat 102 à travers ces trous, c'est-à-dire en fonction de la surface de matériau getter que l'on souhaite avoir dans la cavité 108.

La figure 2 représente un exemple de trous pouvant être réalisés à travers le deuxième substrat 106. Sur cet exemple, trois trous 112, de forme et de dimensions par exemple similaires aux trous 112 représentés sur la figure 1D, sont réalisés à travers le deuxième substrat 106. De plus, un quatrième trou 118 est réalisé à travers le deuxième substrat 106. Ce quatrième trou 118 a une section, dans le plan (X,Y), c'est-à-dire dans le plan de la face 115 du deuxième substrat 106, de forme sensiblement rectangulaire. La dimension du quatrième trou 118 selon l'axe Y peut être par exemple comprise entre environ 1 µm et 100 µm, et le rapport de la dimension du trou 118 selon l'axe X sur la dimension du trou 118 selon l'axe Y est par exemple compris entre environ 1 et 100. Un cinquième trou 120 est réalisé à travers le capot 106. Ce cinquième trou 120 à une forme d'équerre et correspond à deux trous de section, dans le plan (X,Y), de forme sensiblement rectangulaire disposés l'un à côté de l'autre, jointifs et dont les dimensions peuvent correspondre à celles indiquées ci-dessus pour le quatrième trou 118.

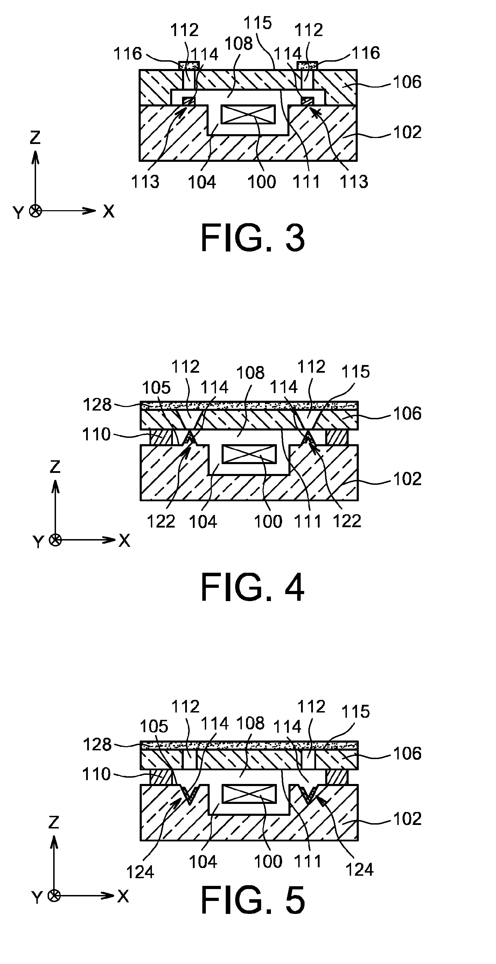

Dans une variante du procédé d'encapsulation précédemment décrit, le deuxième substrat 106 peut-être assemblé directement au premier substrat 102, sans faire appel au cordon de scellement 110. La figure 3 représente une telle encapsulation.

Sur cet exemple, le deuxième substrat 106 est directement en contact contre le premier substrat 102. Lorsque le deuxième substrat 106 est composé d'un semi-conducteur par exemple similaire à celui du premier substrat 102, l'assemblage entre le deuxième substrat 106 et le premier substrat 102 peut être réalisé par un scellement direct silicium/silicium, ou encore par thermo-compression. Lorsque le deuxième substrat 106 est composé de verre, l'assemblage entre le deuxième substrat 106 et le premier substrat 102 peut être réalisé par un scellement anodique. On voit sur l'exemple de la figure 3 que le deuxième substrat 106 comporte une partie gravée, au niveau de sa face qui est en contact avec le premier substrat 102, destinée à former une partie de la cavité 108 et qui évite au second substrat 106 d'être en contact avec le micro-dispositif 100. Là encore, les portions de matériau getter 114 n'obstruent pas les trous 112 et ne sont pas en contact avec le deuxième substrat 106.

Dans les exemples précédemment décrits, les portions de matériau getter 114 sont déposées sur les parties 113 du premier substrat 102 correspondant à des surfaces planes. En variante, il est possible de structurer ces parties 113 afin de former des reliefs sur lesquels les portions de matériau 114 peuvent être déposées. Ainsi, comme représenté sur la figure 4, le premier substrat 102 peut comporter, au niveau des parties 113 du premier substrat 102, des bosses 122, ou plus généralement des portions formant un relief par rapport au reste de la surface du premier substrat 102, disposées en regard des trous 112. Les portions de matériau getter 114 sont déposées sur les parois du relief formé par ces bosses 122 à travers les trous 112. On réalise ce relief tel que, pour un même encombrement au niveau de la face du premier substrat 102 se trouvant dans la cavité 108, la surface de matériau getter des portions 114 en contact avec l'atmosphère de la cavité 108 soit plus importante que celle obtenue pour des portions de matériau getter déposées sur une surface plane du premier substrat 102 (comme sur la figure 1F). Ce relief formé au niveau des parties 113 du premier substrat 102 destinées à recevoir les portions de matériau getter 114 augmente donc, pour un même encombrement du matériau getter sur le premier substrat 102, la capacité de pompage gazeux du matériau getter déposé dans la cavité 108.

Le relief formé par les bosses 122 a une épaisseur (dimension selon l'axe Z représenté sur la figure 4, correspondant à la hauteur des bosses 122 par rapport au reste de la face 105 du premier substrat 102) par exemple comprise entre environ 1 µm et 10 µm, et est par exemple réalisé, préalablement à l'assemblage du deuxième substrat 106 au premier substrat 102, par des étapes de photolithographie et gravure par vois sèche (par exemple du type RIE) de la face 105 du premier substrat 102 destinée à être disposée dans la cavité 108. Les bosses 122 peuvent être réalisées avant, pendant ou après la réalisation du micro-dispositif 100. Là encore, les portions de matériau getter 114 n'obstruent pas les trous 112 et ne sont pas en contact avec le deuxième substrat 106.

Sur l'exemple de la figure 4, les trous 112 n'ont pas une forme cylindrique comme dans les précédents exemples, mais une forme « d'entonnoir ». De manière générale, quelque soit la forme des sections des trous 112 au niveau des faces 111 et 115 du second substrat 106, les dimensions de la section des trous 112 au niveau de la face 111 du deuxième substrat 106 formant une paroi de la cavité 108 peuvent être inférieures aux dimensions de la section des trous 112 au niveau de la face 115 du deuxième substrat 106 qui est opposée à la face 111. De tels trous 112 permettent de faciliter le dépôt des portions de matériau getter 114 à travers les trous 112. Il est possible de réaliser de tels trous grâce au fait que le capot de la cavité 108 soit formé par un substrat et non par une couche mince qui ne présenterait pas une tenue mécanique suffisante. Le principe de réalisation des trous en forme « d'entonnoir » peut également s'appliquer aux autres exemples de trous précédemment décrits et comportant une section de forme autre que circulaire.

Dans une autre variante représentée sur la figure 5, le relief formé au niveau des portions 113 du premier substrat 102 correspond à des creux 124 réalisés dans le substrat 102, en regard des trous 112.

Les portions de matériau getter 114 sont déposées sur les parois des creux 124, à travers les trous 112. Comme pour les bosses 122, la surface de matériau getter des portions 114 ainsi déposées dans la cavité 108 est plus importante que pour des portions de matériau getter qui seraient déposées sur une surface plane du premier substrat 102, à encombrement équivalent sur le premier substrat 102. Ces creux 124 peuvent être réalisés avec une profondeur comprise entre environ 1 µm et 10 µm, par exemple par photolithographie et gravure par voie sèche (par exemple de type RIE) du substrat 102. Là encore, les portions de matériau getter 114 n'obstruent pas les trous 112 et ne sont pas en contact avec le deuxième substrat 106.

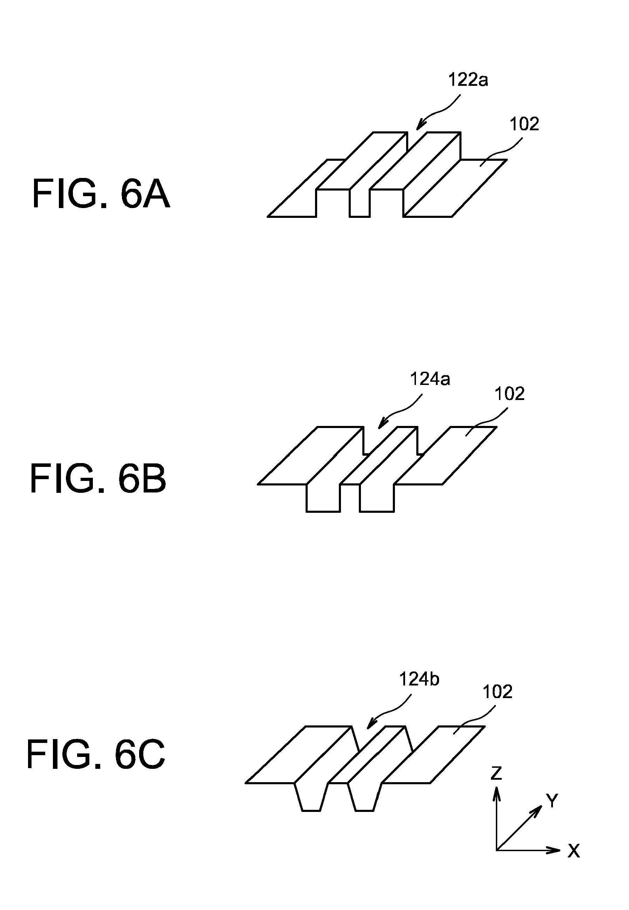

Les bosses 122 et les creux 124 peuvent être réalisés selon des formes différentes. Sur l'exemple de la figure 4, chacune des bosses 122 présente une section, dans le plan (X,Z), de forme sensiblement triangulaire. Il est également possible de réaliser, en regard d'un unique trou, plusieurs bosses disposées les unes à côté des autres, formant ainsi une ou plusieurs cannelures, ou créneaux, dans lesquelles est déposée une portion 114 de matériau getter. Par exemple, comme représenté sur la figure 6A, deux bosses 122a formées l'une à côté de l'autre en regard d'un unique trou, présentent chacune une section, dans le plan (X,Z), de forme sensiblement rectangulaire.

L'espace entre les bosses 122a forme une cannelure. Les bosses 122 peuvent également être réalisées selon des formes et profils différents de ceux décrits ici.

De même, les creux 124 peuvent être réalisés selon différents types de profils. Sur l'exemple de la figure 5, chacun des creux 124 présente une section, dans le plan (X,Z), de forme sensiblement triangulaire inversée. Comme pour les bosses, il est possible de réaliser, en regard d'un unique trou, plusieurs creux disposés les uns à côté des autres, formant ainsi une ou plusieurs cannelures, ou créneaux, dans lesquelles sera déposée une portion de matériau getter 114. Par exemple, comme représenté sur la figure 6B, deux creux 124a disposés l'un à côté de l'autre en regard d'un unique trou, présentent chacun une section, dans le plan (X,Z), de forme sensiblement rectangulaire. Dans un autre exemple représenté sur la figure 6C, des creux 124b sont réalisés dans le substrat 102. Ces creux 124b sont tels qu'ils présentent une section, dans le plan (X,Z), de forme sensiblement trapézoïdale. De tels creux 124b sont par exemple réalisés par photolithographie et gravure du substrat 102 par voie humide (par exemple avec une solution de KOH). Les creux 124 peuvent également être réalisés selon des formes et profils différents de ceux décrits ici.

La distance entre le deuxième substrat 106 et le premier substrat 102 peut être comprise entre quelques microns et quelques dizaines de microns (et par exemple inférieure à environ 100 µm). Les dimensions du relief formé par les creux ou bosses peuvent être telles que ces dimensions soient inférieures ou égales à celles du trou en regard duquel se trouve le relief. Sur les exemples des figures 6A à 6C, la dimension selon l'axe X de chaque creux ou bosse peut être comprise entre quelques microns et environ 1 millimètre, cette dimension pouvant correspondre sensiblement à la dimension du trou selon ce même axe.

La dimension selon l'axe Y de chaque creux ou bosse peut être comprise entre quelques microns et quelques dizaines de microns, et par exemple inférieure à environ 100 µm. Afin d'augmenter la surface de matériau getter de la portion getter, il est possible de réaliser le plus possible de creux et/ou de bosses en regard de chaque trou.

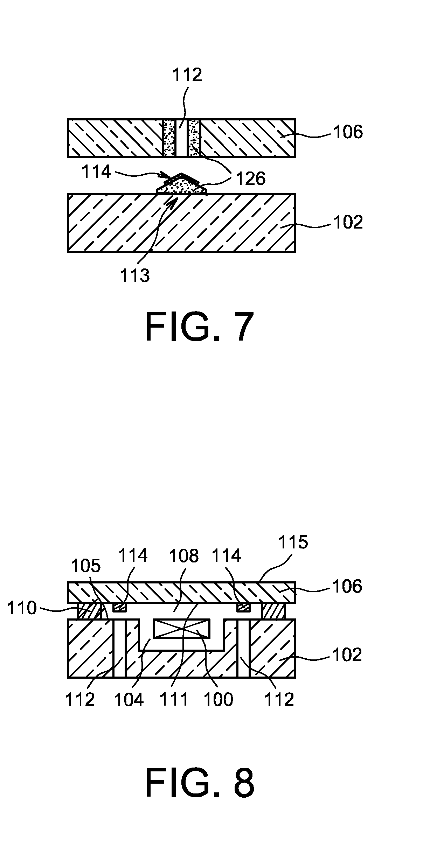

Pour former un relief pouvant présenter des dimensions importantes sur le premier substrat 102, il est possible de former un ou plusieurs trous 112 dans le deuxième substrat 106 dont la plus petite section correspond sensiblement à la section de la base du relief à réaliser. Ces trous 112 peuvent être de géométrie quelconque, et avantageusement conique comme représenté sur la figure 4. Un matériau de pré-bouchage 126 est alors utilisé pour obturer partiellement les trous 112, préalablement au dépôt du matériau getter (voir figure 7). Un tel matériau de pré-bouchage peut être déposé, par exemple par CVD lorsque ce matériau est de l'oxyde de silicium ou un nitrure, sur les parois latérales des trous 112 et être déposé également sur le substrat 102, en regard des trous 112, formant ainsi, au niveau des portions 113 du premier substrat 102, un relief composé de bosses sur lesquelles les portions de matériau getter 114 peuvent être ensuite déposées, le matériau getter étant ensuite déposé à travers l'espace restant des trous 112 non occupé par le matériau de pré-bouchage 126. Le matériau de pré-bouchage 126 déposé contre les parois latérales des trous 112 facilite le bouchage ultérieur des trous qui peut être réalisé par un seul dépôt de matériau, notamment un matériau getter. Le pré-bouchage des trous 112 peut être réalisé tel que les trous après ce pré-bouchage présentent un diamètre égal à quelques microns. Là encore, les portions de matériau getter 114 n'obstruent pas les trous 112 et ne sont pas en contact avec le deuxième substrat 106.

Dans les exemples précédemment décrits, les trous 112 sont réalisés à travers le deuxième substrat 106 après avoir solidarisé le deuxième substrat 106 au premier substrat 102. Toutefois, il est également possible de réaliser ces trous 112 à travers le deuxième substrat 106 préalablement à l'assemblage des deux substrats. Les trous 112 peuvent dans ce cas être réalisés par une gravure anisotrope DRIE (gravure ionique réactive profonde) lorsque le deuxième substrat 106 est composé de silicium. Si le deuxième substrat 106 est composé de verre, les trous 112 peuvent être réalisés par un usinage de type sablage. En réalisant les trous 112 préalablement à l'assemblage des substrats 102 et 106 entre eux, on facilite le dégazage lors de l'assemblage des surfaces internes définissant la cavité 108.

Dans les modes de réalisation et variantes précédemment décrits, les trous 112 sont réalisés à travers le deuxième substrat 106 qui forme le capot. Dans un autre mode de réalisation, il est possible que les trous 112 soient réalisés à travers le premier substrat 102. Dans ce cas, les trous sont réalisés de préférence préalablement à l'assemblage du deuxième substrat 106 sur le premier substrat 102. Ce mode de réalisation est avantageusement réalisé lorsque le micro-dispositif 100 nécessite une étape de libération consistant à libérer par exemple une partie mobile du micro-dispositif 100 par rapport à une partie fixe. Le lien entre les deux parties est généralement assuré par une couche sacrificielle, par exemple composée d'oxyde de silicium. L'étape de libération peut dans ce cas être mise en oeuvre après avoir réalisé les trous. Il est également possible de réaliser les trous à travers le premier substrat 102 après avoir solidarisé le deuxième substrat 106 au premier substrat 102. Dans tous les cas, il est possible de réaliser un amincissement du premier substrat 102 préalablement à la réalisation des trous à travers le premier substrat 102 par photolithographie et gravure DRIE. Le deuxième substrat 106 sert alors de capot mais également de poignée mécanique.

Lorsque les trous 112 sont réalisés à travers le premier substrat 102, le deuxième substrat 106 sert de substrat d'accueil pour le matériau getter 114 qui est déposé sur la face 111 du deuxième substrat 106. Le premier substrat 102 forme alors le substrat percé à travers lequel le matériau getter est déposé.

La figure 8 représente une telle configuration. Toute les variantes et options précédemment décrites en liaison avec les configurations dans lesquelles le premier substrat 102 sert de substrat d'accueil et le deuxième substrat 106 correspond au substrat percé peuvent d'appliquer à ce mode de réalisation dans lequel le premier substrat 102 correspond au substrat percé et le deuxième substrat 106 correspond au substrat d'accueil.

## Revendications

1. Procédé d'encapsulation d'un micro-dispositif (100) dans une cavité (108) formée entre au moins un premier (102) et un deuxième substrat (106), comportant au moins les étapes de :
- réalisation du micro-dispositif (100) dans et/ou sur le premier substrat (102),
- report et solidarisation du deuxième substrat (106) au premier substrat (102), formant la cavité (108) dans laquelle est disposé le micro-dispositif (100),
- réalisation d'au moins un trou (112, 118, 120) à travers l'un des deux substrats (102, 106), appelé substrat percé, et débouchant dans la cavité (108) en regard d'une partie (113) de l'autre des deux substrats (102, 106), appelé substrat d'accueil,
- dépôt d'au moins une portion de matériau getter (114) sur ladite partie (113) du substrat d'accueil (102, 106) à travers le trou (112, 118, 120) tel que le matériau getter (114) n'obstrue pas le trou (112, 118, 120),
- fermeture hermétique de la cavité (108) par obturation du trou (112, 118, 120).

2. Procédé d'encapsulation selon la revendication 1, dans lequel les dimensions du trou (112, 118, 120), dans un plan parallèle à l'une des faces principales (111, 115) du substrat percé (106), sont supérieures ou égales à environ 10 µm, et/ou dans lequel l'épaisseur du substrat percé (106) est supérieure ou égale à environ 50 µm.

3. Procédé d'encapsulation selon l'une des revendications précédentes, comportant en outre la mise en oeuvre, avant le report et la solidarisation du deuxième substrat (106) au premier substrat (102), d'une étape de structuration de ladite partie (113) du substrat d'accueil (102), formant un relief (122, 124) au niveau de ladite partie (113) du substrat d'accueil (102), la portion de matériau getter (114) étant déposée sur au moins une partie des parois dudit relief qui est tel que, pour un même encombrement sur le substrat d'accueil (102, 106), la surface de matériau getter (114) en contact avec l'atmosphère de la cavité (108) soit plus importante que celle obtenue pour un matériau getter déposé sur une surface plane du substrat d'accueil (102, 106).

4. Procédé d'encapsulation selon la revendication 3, dans lequel le relief (122, 124) forme une ou plusieurs rainures au niveau de ladite partie (113) du substrat d'accueil (102).

5. Procédé d'encapsulation selon l'une des revendications précédentes, dans lequel le deuxième substrat (106) est solidarisé au premier substrat (102) par l'intermédiaire d'un cordon de scellement (110) formant des parois latérales de la cavité (108) ou par un scellement réalisé directement entre le deuxième substrat (106) et le premier substrat (102).

6. Procédé d'encapsulation selon l'une des revendications précédentes, comportant en outre, entre l'étape de report et de solidarisation du deuxième substrat (106) au premier substrat (102) et l'étape de fermeture hermétique de la cavité (108), la mise en oeuvre d'un amincissement du substrat percé (106).

7. Procédé d'encapsulation selon l'une des revendications précédentes, dans lequel, avant la mise en oeuvre de l'étape de report et de solidarisation du deuxième substrat (106) au premier substrat (102), le trou (112, 118, 120) est réalisé en partie à travers une face (111) du substrat percé (106) destinée à former une paroi de la cavité (108).

8. Procédé d'encapsulation selon l'une des revendications précédentes, comportant en outre, entre l'étape de réalisation du trou (112, 118, 120) et l'étape de dépôt de la portion de matériau getter (114), la mise en oeuvre d'un dégazage des parois de la cavité (108) par un traitement thermique du premier (102) et du deuxième substrat (106), et/ou la mise en oeuvre d'un dépôt d'au moins un matériau (126) contre les parois du trou (112, 118, 120), bouchant en partie le trou (112, 118, 120), et/ou la mise en oeuvre d'un dépôt d'au moins un matériau (126) sur ladite partie (113) du substrat d'accueil (102) en formant un relief sur ladite partie (113) du substrat d'accueil (102), la portion de matériau getter (114) étant déposée sur au moins une partie des parois dudit relief.

9. Procédé d'encapsulation selon l'une des revendications précédentes, dans lequel la fermeture hermétique de la cavité (108) par obturation du trou (112, 118, 120) est réalisée par la mise en oeuvre d'au moins une étape de dépôt, sur le substrat percé (106), d'au moins une portion (116) et/ou une couche (128) de matériau recouvrant au moins le trou (112, 118, 120), et/ou au moins une étape de solidarisation d'un troisième substrat (130) sur le substrat percé (106).

10. Procédé d'encapsulation selon l'une des revendications précédentes, comportant en outre, après la fermeture hermétique de la cavité (108) par obturation du trou (112, 118, 120), la mise en oeuvre d'un traitement thermique activant thermiquement la portion de matériau getter (114).

11. Procédé d'encapsulation selon l'une des revendications précédentes, comportant en outre, préalablement au dépôt de la portion de matériau getter (114), une étape de dépôt, au moins sur ladite partie (113) du substrat d'accueil (102), d'au moins un matériau d'ajustement apte à modifier la température d'activation thermique de la portion (114) de matériau getter, la portion de matériau getter (114) étant déposée sur ledit matériau d'ajustement.

12. Procédé d'encapsulation selon l'une des revendications précédentes, dans lequel les dimensions du trou (112, 118, 120), au niveau d'une face (111) du substrat percé (106) formant une paroi de la cavité (108), sont inférieures aux dimensions du trou (112, 118, 120) au niveau d'une face (115) du substrat percé (106) opposée à celle formant une paroi de la cavité (108).

13. Procédé d'encapsulation selon l'une des revendications précédentes, dans lequel l'étape de réalisation du trou (112, 118, 120) est mise en oeuvre avant l'étape de report et de solidarisation du deuxième substrat (106) au premier substrat (102).

14. Procédé d'encapsulation selon l'une des revendications précédentes, dans lequel la portion de matériau getter (114) déposée n'est pas en contact avec le substrat percé.
